# EUROPÄISCHE PATENTSCHRIFT

(11) **EP 0 764 983 B1**
(45) Veröffentlichungstag und Bekanntmachung des Hinweises auf die Patenterteilung: **21.11.2001**
(21) Anmeldenummer: 96114483.9
(22) Anmeldetag: 10.09.1996
(51) Int. Cl.: H01L 21/8238, H01L 21/765

(54) **Halbleiteranordnung und Verfahren zu ihrer Herstellung**
Semiconductor device and method of manufacturing the same
Dispositif semi-conducteur et procédé de fabrication

(30) Priorität: 19.09.1995 DE 19534784
(43) Veröffentlichungstag der Anmeldung: 26.03.1997
(73) Patentinhaber: Infineon Technologies AG, 81669 München (DE)
(72) Erfinder: Kerber, Martin, Dr. rer. nat., 81827 München (DE)
(74) Vertreter: Zedlitz, Peter, Dipl.-Inf.

(56) Entgegenhaltungen:
- EP-A- 0 181 501
- EP-A- 0 417 715
- DE-A- 3 942 648
- DE-A- 4 214 302

## Beschreibung

Die Erfindung betrifft ein Verfahren zur Herstellung einer Halbleiteranordnung.

Feldplatten-Isolationstransistoren sind Halbleiteranordnungen, die zur gegenseitigen Isolation von zwei in einem Substrat benachbarten Wannen dienen, welche mit Dotieratomen komplementären Typs dotiert sind. Sie können alternativ zu sogenannten LOCOS-Isolierungen vorgesehen werden. Durch die Isolationstransistoren soll das Auftreten von parasitären MOS-Transistoren zwischen den Wannen verhindert werden. Hierzu sind die Isolationstransistoren zwischen den Wannen angeordnet und weisen oberhalbe des Substrates über einem dünnen Gateoxid eine sogenannte Feldplatte auf, die aus einer dotierbaren Schicht besteht und sich teilweise über beide Wannen erstreckt. Bereiche der Feldplatte, die sich über einer der Wannen befinden, sind mit Ladungsträgern vom jeweils gleichen Typ wie die darunter befindlichen Wannen dotiert und weisen das gleiche Potential wie die jeweilige Wanne auf. Um die Feldplatte von über ihr verlaufenden Leiterbahnen zu isolieren, weisen die Isolationstransistoren oberhalb der Feldplatte eine dicke Feldoxidschicht auf.

Die Herstellung eines Feldplatten-Isolationstransistors kann in der Weise erfolgen, daß zunächst die Wannen im Substrat erzeugt und anschließend die für die Herstellung des Isolationstransistors notwendigen Schichten gebildet werden.

Die EP-A1-0 417 715 beschreibt ein Verfahren zur Herstellung aneinander angrenzender und sich berührender Wannen komplementären Leitungstyps. Dabei wird eine Oxidschicht teilweise entfernt und dort durch thermische Oxidation höhenversetzt wiederhergestellt. Der Höhenversatz wird zur Maskierung für einen nachfolgenden Dotierungsschritt genutzt.

Die DE-A1-39 42 648 beschreibt ein Verfahren zur Herstellung einer Halbleiterstruktur mit zwei einander berührenden und komplementär zueinander dotierten Wannen. Die zuerst eingebrachte Wanne ist mit einem Feldoxid bedeckt, das bei der Implantation der zweiten Wanne als Implantationsmaske dient.

In der vor dem Anmeldetag dieser Anmeldung noch nicht veröffentlichten deutschen Patentanmeldung mit dem Aktenzeichen 195 26 568.8 ist ein Verfahren zur Herstellung eines Feldplatten-Isolationstransistors beschrieben, bei dem die Dotierung jeweils einer der Wannen und des entsprechenden Feldplattenbereiches in einem Schritt durchgeführt wird. Die Dotierkonzentration jedes Feldplattenbereiches entspricht dann derjenigen der darunter liegenden Wanne und ist somit relativ gering, so daß die Feldplatte in einem Stück ausgeführt werden kann. In der genannten Anmeldung ist beschrieben, daß zur Herstellung des Feldplatten-Isolationstransistors zunächst die Gateoxidschicht, die Feldplattenschicht und die Feldoxidschicht aufgebracht und diese anschließend strukturiert werden. Hierauf werden durch Ionenimplantation gleichzeitig jeweils eine der Wannen und der darüber befindliche Feldplattenbereich dotiert, wobei die Wannengebiete, die sich unterhalb des Isolationstransistors befinden, durch die Feldoxidschicht hindurch dotiert werden. Dieses Verfahren weist daher den Nachteil auf, daß sehr große Energien für die Durchführung der Implantationsdotierung notwendig sind, um eine ausreichend tiefe Dotierung der Wannen auch unter der Feldplatte (und damit unterhalb der dicken Feldoxidschicht) zu erreichen. Eine ausreichende Wannentiefe ist jedoch notwendig, damit die Spannungsfestigkeit der Anordnung nicht zu gering ist.

Der Erfindung liegt die Aufgabe zugrunde, ein verbessertes Verfahren zur Herstellung von Halbleiteranordnungen, z.B. Feldplatten-Isolationstransistoren anzugeben.

Diese Aufgabe wird mit dem Verfahren gemäß Anspruch 1 gelöst. Erfindungsgemäß ist eine beim Stand der Technik nicht vorhandene Opferschicht vorgesehen. Durch die Entfernung eines ersten Bereiches der Opferschicht mittels einer ersten Maskentechnik entsteht eine Kante der Opferschicht, die zur Durchführung einer zweiten Maskentechnik als Justagepunkt verwendet wird.

Die Erfindung ist für alle Halbleiteranordnungen anwendbar, bei deren Herstellung für die Durchführung von Prozeßschritten keine Justiermarke zur Verfügung steht, die durch für eine bestimmungsgemäße elektrische Funktion der fertiggestellten Halbleiteranordnung notwendige Strukturen gebildet wird. Die erfindungsgemäße Opferschicht ist dagegen nicht für die elektrische Funktion der Halbleiteranordnung notwendig, sie ist also beispielsweise schaltungstechnisch nicht vorgesehen und dient auch nicht zur Isolation verschiedener Schichten voneinander, vielmehr funktioniert die fertiggestellte Halbleiteranordnung unabhängig vom Vorhandensein der Opferschicht. Diese ist allein für die Herstellung der Halbleiteranordnung notwendig und ermöglicht dabei die Durchführung der notwendigen Herstellungsschritte in der gewünschten Reihenfolge. Die Erfindung ermöglicht die Durchführung von Herstellungsschritten, durch welche für die elektrische Funktion notwendige Strukturen gebildet werden, in einer Reihenfolge, die mangels geeigneter Justiermarken dieser Strukturen ohne die für die elektrische Funktion unerhebliche Opferschicht in dieser Reihenfolge nicht durchführbar sind.

Durch die Erfindung ist es möglich, im Falle daß die Halbleiteranordnung ein Feldplatten-Isolationstransistor ist, bereits vor dem Aufbringen einer zweiten Isolationsschicht (beispielsweise einer Feldoxidschicht) oberhalb der dotierbaren Schicht (bzw. Feldplattenschicht) eine Dotierung letzterer und der darunter liegenden Wannen durchzuführen. Die Opferschicht ist notwendig, um eine Justierung der zweiten Maskentechnik gegenüber der ersten Maskentechnik bzw. eine Justierung der zweiten Wanne und des zweiten Bereiches der dotierbaren Schicht zur ersten Wanne und zum ersten Bereich der dotierbaren Schicht zu ermöglichen.

Dadurch, daß die Dotierung der Wannen vor Aufbringen der zweiten Isolationsschicht und folglich nur durch die dünne erste Isolationsschicht und die dotierbare Schicht hindurch erfolgt, kann eine Implantationsdotierung mit im Vergleich zum geschilderten Stand der Technik relativ niedrigeren Energien durchgeführt werden, um überall eine ausreichende Wannentiefe zu erreichen, auch unterhalb der dotierbaren Schicht. Die Wannentiefen sind bei Anwendung des erfindungsgemäßen Verfahrens innerhalb und außerhalb der Halbleiteranordnung nahezu gleich, so daß man eine homogene laterale Dotierstoffverteilung erreicht.

Beim geschilderten Stand der Technik erfolgt dagegen die Dotierung, nachdem mittels einer Maskentechnik der komplette (bereits die zweite Isolationsschicht aufweisende) Isolationstransistor strukturiert worden ist. Für die Justierung der nachfolgenden zwei Maskentechniken zur Herstellung der Wannen wird dort der dann bereits strukturierte Isolationstransistor verwendet. Die Dotierung erfolgt dabei durch die dicke zweite Isolationsschicht, wodurch eine homogene laterale Dotierstoffverteilung unterhalb des Felplatten-Isolationstransistors verhindert wird.

Weiterbildungen der Erfindung sind in den abhängigen Ansprüchen gekennzeichnet.

Gemäß einer Weiterbildung der Erfindung wird bei der Durchführung der zweiten Maskentechnik ein Steg der Opferschicht zwischen den nunmehr entfernten ersten und zweiten Bereichen der Opferschicht stehen gelassen, so daß sich bei einer nachfolgenden ganzflächigen Aufbringung einer zweiten Isolationsschicht über diesem Steg eine Erhebung in der zweiten Isolationsschicht ergibt. Diese Erhebung dient dann dazu, eine Justierung einer dritten Maskentechnik zur Strukturierung der Halbleiteranordnung durchzuführen.

Sind mehrere gleichartige erfindungsgemäße Halbleiteranordnungen auf einem Substrat herzustellen, die sich im Gesichtsfeld eines Belichtungsgerätes befinden, reicht es aus, für jeden Herstellungsschritt für alle Halbleiteranordnungen gleichzeitig nur eine Maske zu verwenden. Es ist dann möglich, für die Justierung der zweiten Maskentechnik nur zwei der durch die erste Maskentechnik entstehenden Kanten zu verwenden (zur Justierung einer Ebene sind immer zwei Justiermarken erforderlich). Außerdem reicht es dann aus, pro Gesichtsfeld des Belichtungsgerätes lediglich bei zwei der Halbleiteranordnungen einen erfindungsgemäßen Steg der Opferschicht zur Bildung der Erhebung in der zweiten Isolationsschicht für die Justierung der dritten Maskentechnik vorzusehen. Wo kein Steg vorhanden ist, können die Wannen direkt zueinander benachbart sein und müssen keinen gegenseitigen Abstand aufweisen.

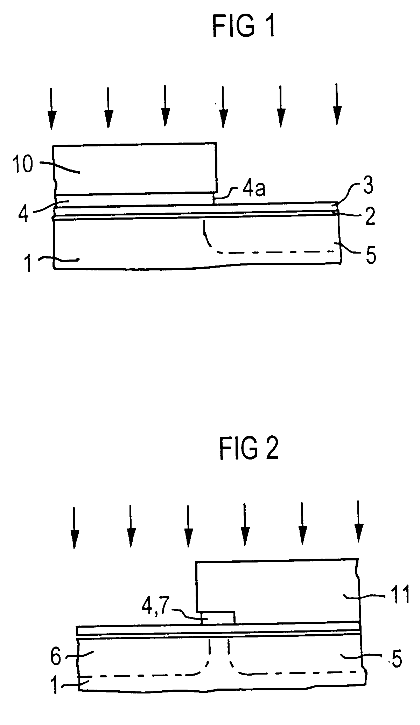

Die Erfindung wird im folgenden anhand der Figuren 1 bis 4, welche nur die für die Erfindung wesentlichen Verfahrensschritte veranschaulichen, bezüglich eines Ausführungsbeispiels näher erläutert. Es wird die Herstellung einer Halbleiteranordnung beschrieben, die ein Feldplatten-Isolationstransistor ist.

Figur 1: Auf ein Substrat 1, welches beispielsweise im wesentlichen Silizium enthält, wird eine erste Isolationsschicht 2 zur Bildung des Gateoxids der Halbleiteranordnung bzw. des Feldplatten-Isolationstransistors aufgebracht. Darauf wird eine dotierbare Schicht 3 (in diesem Fall eine Feldplattenschicht), beispielsweise aus Silizium, und eine Opferschicht 4, beispielsweise aus einem Oxid (z. B. TEOS), gebildet. In einer ersten Maskentechnik 10 wird nun ein Teil der Opferschicht 4 abgedeckt und beispielsweise durch Ätzung ein von der Maske 10 nicht abgedeckter erster Bereich der Opferschicht 4 entfernt. Auf diese Weise wird ein darunter befindlicher erster Bereich der dotierbaren Schicht 3 freigelegt. Anschließend wird durch eine erste Dotierung (beispielsweise durch Ionenimplantation) der erste Bereich der dotierbaren Schicht 3 sowie der unter diesem befindliche Teil des Substrats 1 mit einer ersten Ladungsträgerart dotiert, wodurch im Substrat 1 eine erste Wanne 5 entsteht.

Figur 2: Um eine zweite Wanne 6 mit einem Leitungstyp, der zu demjenigen der ersten Wanne 5 komplementär ist, herzustellen, wird mittels einer zweiten Maskentechnik 11 der erste Bereich der dotierbaren Schicht 3, welcher bereits in der ersten Maskentechnik 10 dotiert worden ist, abgedeckt. Hierbei dient eine in Figur 1 sichtbare Kante 4a der Opferschicht 4, welche durch das Entfernen des ersten Bereiches der Opferschicht 4 entstanden ist, zur Justierung der zweiten Maskentechnik 11. Die zweite Maske 11 in Figur 2 bedeckt nicht nur den ersten Bereich der dotierbaren Schicht 3, sondern auch einen angrenzenden Teil der an dieser Stelle noch nicht entfernten Opferschicht 4, der nach der Durchführung der nachfolgend beschriebenen Schritte die Form eines Steges 7 hat. Analog zum Vorgehen gemäß Figur 1 entfernt man nun nämlich einen von der zweiten Maske 11 nicht abgedeckten zweiten Bereich der Opferschicht 4. Hierdurch wird ein darunter befindlicher zweiter Bereich der dotierbaren Schicht 3 freigelegt, der analog zu Figur 1 gleichzeitig mit dem darunter befindlichen Teil des Substrats 1 mit Ladungsträgern eines zweiten Leitungstyps dotiert wird. Hierdurch entsteht im Substrat 1 eine zweite Wanne 6.

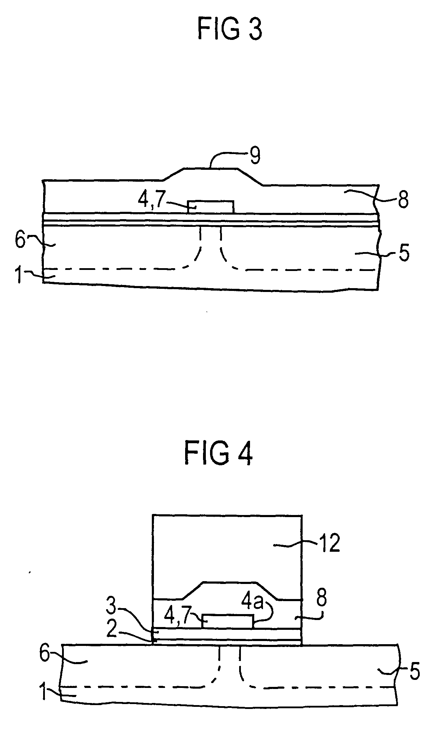

Figur 3: Anschließend wird eine ganzflächige zweite Isolationsschicht 8 aufgebracht, welche beispielsweise eine Feldoxidschicht sein kann. Aufgrund des bei dieser Ausführungsform der Erfindung vorhandenen Steges 7 bildet sich bei Abscheidung dieser zweiten Isolationsschicht 8, die eine nahezu konstante Dicke aufweist, über dem Steg 7 eine Erhebung 9 in der zweiten Isolationsschicht 8.

Figur 4: Die Erhebung 9 dient abschließend zur Justierung einer der Strukturierung des Isolationstransistors dienenden dritten Maske 12, welche den Teil der zweiten Isolationsschicht 8 abdeckt, wo der Isolationstransistor gebildet werden soll. Die von der dritten Maske 12 nicht abgedeckten Bereiche der ersten Isolationsschicht 2, der dotierbaren Schicht 3 sowie der zweiten Isolationsschicht 8 können dann, beispielsweise durch anisotrope Ätzung, selektiv zum Substrat 1 entfernt werden.

Die unterschiedlich dotierten Bereiche der dotierbaren Schicht 3 sollten während eines Betriebes einer integrierten Schaltung, deren Bestandteil der Isolationstransistor ist, mit jeweils den gleichen Potentialen wie die unter ihnen befindlichen Wannen 5, 6 verbunden sein. Um dies zu erreichen, ist es vorteilhaft, nach der Herstellung des Isolationstransistors eine elektrische Verbindung zwischen jeder der beiden Wannen 5, 6 zu den jeweils darüber liegenden Bereichen der dotierbaren Schicht 3 zu schaffen. Dies kann nach der in Figur 4 dargestellten Strukturierung geschehen. Verfahren zur Herstellung derartiger Kontakte sind dem Fachmann bekannt.

## Patentansprüche

1. Verfahren zur Herstellung einer Halbleiteranordnung mit folgenden Schritten:
- Auf einem Substrat (1) werden nacheinander eine erste Isolationschicht (2), eine dotierbare Schicht (3) und eine Opferschicht (4) aufgebracht,
- mit einer ersten Maskentechnik (10) wird ein erster Bereich der Opferschicht (4) entfernt, wobei in ihr eine Kante (4a) entsteht,
- ein dadurch freigelegter erster Bereich der dotierbaren Schicht (3) sowie das darunter liegende Substrat (1) werden mit einer ersten Ladungsträgerart dotiert, wodurch im Substrat (1) eine erste Wanne (5) entsteht,
- mit einer zweiten Maskentechnik (11) wird ein zweiter Bereich der Opferschicht (4) entfernt, wobei ihre Kante (4a) zur Justierung der zweiten Maskentechnik (11) dient,
- ein dadurch freigelegter zweiter Bereich der dotierbaren Schicht (3) sowie das darunter liegende Substrat (1) werden mit einer zweiten Ladungsträgerart dotiert, wodurch im Substrat (1) eine zweite Wanne (6) entsteht.

2. Verfahren nach Anspruch 1,
bei dem bei Durchführung der zweiten Maskentechnik (11) ein Steg (7) der Opferschicht (4) erhalten bleibt, der sich zwischen dem ersten und dem zweiten Bereich der Opferschicht (4) befindet.

3. Verfahren nach Anspruch 2,
bei dem eine zweite Isolationsschicht (8) aufgebracht wird, wobei über dem Steg (7) eine Erhebung (9) in der zweiten Isolationsschicht (8) entsteht.

4. Verfahren nach Anspruch 3,
bei dem die Halbleiteranordnung mit einer dritten Maskentechnik (12) strukturiert wird, indem außerhalb eines Bereiches, über dem die Halbleiteranordnung sich erstrecken soll, die erste Isolationsschicht (2), die dotierbare Schicht (3) und die zweite Isolationsschicht (8) von der Oberfläche des Substrates (1) entfernt werden, wobei die Erhebung (9) zur Justierung der dritten Maskentechnik (12) dient.

5. Verfahren nach einem der Ansprüche 1 bis 4,
bei dem als dotierbare Schicht (3) eine Siliziumschicht verwendet wird.

6. Verfahren nach einem der Ansprüche 1 bis 5,
bei dem als Opferschicht (4) eine Oxidschicht verwendet wird.

## Claims

1. Method for fabricating a semiconductor arrangement, having the following steps:
- a first insulation layer (2) a dopable layer (3) and a sacrificial layer (4) are applied one after the other on a substrate (1),
- using a first mask technique (10) a first region of the sacrificial layer (4) is removed, an edge (4a) being produced in the said layer,
- a first region - uncovered as a result - of the dopable layer (3) and the underlying substrate (1) are doped with a first charge carrier type, thereby producing a first well (5) in the substrate (1),
- using a second mask technique (11), a second region of the sacrificial layer (4) is removed, its edge (4a) serving for the alignment of the second mask technique (11)
- a second region - uncovered as a result - of the dopable layer (3) and the underlying substrate (1) are doped with a second charge carrier type, thereby producing a second well (6) in the substrate (1).

2. Method according to Claim 1,
in which,
when the second mask technique is carried out, a web (7) of the sacrificial layer (4) is preserved, the said web being situated between the first and the second region of the sacrificial layer (4).

3. Method according to Claim 2,
in which a second insulation layer (8) is applied, an elevation (9) being produced in the second insulation layer (8) over the web (7).

4. Method according to Claim 3,
in which the semiconductor arrangement is patterned using a third mask technique (12), by the first insulation layer (2), the dopable layer (3) and the second insulation layer (8) being removed from the surface of the substrate (1), outside a region over which the semiconductor arrangement is intended to extend, the elevation (9) serving for the alignment of the third mask technique (12).

5. Method according to one of Claims 1 to 4,
in which a silicon layer is used as the dopable layer (3).

6. Method according to one of Claims 1 to 5,
in which an oxide layer is used as the sacrificial layer (4).

## Revendications

1. Procédé de fabrication d'un dispositif à semiconducteur comprenant les stades suivants :
- on dépose sur un substrat (1) successivement une première couche (2) d'isolement, une couche (3) pouvant être dopée et une couche (4) sacrificielle,
- par une première technique (10) de masquage, on élimine une première partie de la couche (4) sacrificielle en y créant un bord (4a),
- on dope une première partie ainsi mise à découvert de la couche (3) pouvant être dopée, ainsi que le substrat (1) sous-jacent par un premier type de porteur de charges, en créant ainsi dans le substrat (1) une première cuvette (5),
- par une deuxième technique (11) de masquage, on élimine une deuxième partie de la couche (4) sacrificielle, son bord (4a) servant à l'alignement de la deuxième technique (11) de masquage,
- on dope une deuxième partie ainsi mise à découvert de la couche (3) pouvant être dopée, ainsi que le substrat (1) sous-jacent par un deuxième type de porteur de charges, en créant ainsi dans le substrat (1) une deuxième cuvette (6).

2. Procédé suivant la revendication 1,
dans lequel lorsque l'on effectue la deuxième technique (11) de masquage, il subsiste une nervure (7) de la couche (4) sacrificielle qui se trouve entre la première partie et la deuxième partie de la couche (4) sacrificielle.

3. Procédé suivant la revendication 2, dans lequel on dépose une deuxième couche (8) d'isolement en créant au-dessus de la nervure (7) une surélévation (9) dans la deuxième couche (8) d'isolement.

4. Procédé suivant la revendication 3, dans lequel on structure le dispositif à semiconducteur par une troisième technique (12) de masquage en éliminant, à l'extérieur d'une partie sur laquelle doit s'étendre le dispositif à semiconducteur la première couche (2) d'isolement, la couche (3) pouvant être dopée et la deuxième couche (8) d'isolement de la surface du substrat (1), la surélévation (9) servant à l'alignement de la troisième technique (12) de masquage.

5. Procédé suivant l'une des revendications 1 à 4, dans lequel on utilise comme couche (3) pouvant être dopée une couche de silicium.

6. Procédé suivant l'une des revendications 1 à 5, dans lequel on utilise comme couche (4) sacrificielle une couche d'oxyde.
